# EUROPÄISCHE PATENTSCHRIFT

(11) **EP 0 931 384 B1**
(45) Veröffentlichungstag und Bekanntmachung des Hinweises auf die Patenterteilung: **01.03.2000**
(21) Anmeldenummer: 97909349.9
(22) Anmeldetag: 01.10.1997
(51) Int. Cl.: H04B 1/10, H04B 10/158, H03G 3/30

(54) **SYSTEM ZUR DATENÜBERTRAGUNG**
DATA TRANSMISSION EQUIPMENT
SYSTEME DE TRANSMISSION DE DONNEES

(30) Priorität: 12.10.1996 DE 19642149
(43) Veröffentlichungstag der Anmeldung: 28.07.1999
(73) Patentinhaber: TEMIC Semiconductor GmbH, 74072 Heilbronn (DE)
(72) Erfinder: BLATZ, Werner, D-74211 Leingarten (DE)
(74) Vertreter: Maute, Hans-Jürgen, Dipl.-Ing.
(86) Internationale Anmeldenummer: EP9705414
(87) Internationale Veröffentlichungsnummer: WO9817008

(56) Entgegenhaltungen:
- DE-A- 3 425 335
- US-A- 3 891 319
- US-A- 4 366 378
- BOUCOUVALAS A C: "AMBIENT LIGHT NOISE AND ITS EFFECT ON RECEIVER DESIGN FOR INDOOR WIRELESS OPTICAL LINKS" 1996 IEEE INTERNATIONAL CONFERENCE ON COMMUNICATIONS (ICC), CONVERGING TECHNOLOGIES FOR TOMORROW'S APPLICATIONS DALLAS, JUNE 23 - 27, 1996, Bd. 3 OF 3, 23.Juni 1996, INSTITUTE OF ELECTRICAL & ELECTRONICS ENGINEERS, Seiten 1472-1476, XP000625054

## Beschreibung

Die Erfindung betrifft zunächst ein Verfahren zum Erkennen von netzsynchronen Störsignalen bei einer Datenübertragung, bei der zwischen Nutzsignalen Pausen auftreten, wobei die Zeitdauer der kürzesten Pause Tp sei und wobei die Netzfrequenz f ist.

Ein derartiges Verfahren mit entsprechender Vorrichtung, die analog arbeiten, sind bekannt.

Für die Fernsteuerung z.B. von Geräten der Unterhaltungselektronik wie Fernsehgeräten oder CD-Abspielgeräten, oder auch zur Fernsteuerung von Garagentoren werden vom Benutzer zu betätigende Infrarot-Sender (IR-sender) verwendet, deren IR-Licht von einer Empfangseinrichtung empfangen wird und je nach der gedrückten Taste des IR-Senders den gewünschten Schaltvorgang oder Einstellvorgang auslöst. IR-Licht wird zwar bei derartigen Anwendungen relativ häufig verwendet, die Erfindung ist jedoch nicht auf diese Art der Informationsübertragung durch Licht beschränkt, sondern auch für uV-Licht oder sichtbares Licht sowie für die Informationsübertragung durch Hochfrequenz geeignet.

Die Empfangseinrichtung nimmt nicht nur das vom IR-Sender gesendete Licht auf, sondern auch das Licht anderer Lichtquellen, die von dem in Haushalten üblicherweise benutzten Wechselstromnetz gespeist werden. Diese Störungen sind daher netzsynchrone Störungen, die bei einer einphasigen Netzfrequenz von z.B. 50 Hz je nach Störquelle mit einer Frequenz von 50 Hz oder 100 Hz auftreten.

Um netzsynchrone Störungen mit relativ hoher Sicherheit erkennen zu können, ist eine relativ hohe Zeitkonstante erforderlich. Diese erfordert bei den bekannten analogen Schaltungsanordnungen einen relativ großen Kondensator, der außerhalb der eigentlichen elektronischen Schaltung als zusätzliches Bauelement angeordnet werden muß. Es sind auch vollintegrierte Lösungen ohne externe Bauelemente bekannt, die jedoch keine sichere Unterscheidung zwischen Nutz- und Störsignalen ermöglichen.

Der Erfindung liegt die Aufgabe zugrunde, eine Schaltungsanordnung zu schaffen, die es ermöglicht, alle Bauelemente der Schaltung auf kleinem Raum unterzubringen, die insbesondere keinen großvolumigen externen Kondensator erfordert, und bei der allenfalls noch der Anschluß eines Signalempfängers, für IR-Signalübertragung somit einer IR-Detektorphotodiode, erforderlich ist.

Diese Aufgabe wird gemäß der Erfindung dadurch gelöst, daß eine Zeitspanne Td definiert wird, die kürzer ist als die kürzesten Pausen Tp, aber länger als die größte Periodendauer 1/f oder 1/2f eines netzsynchronen Störers, daß geprüft wird, ob während eines Zeitraums T check > Td, vorzugsweise eines Mehrfachen, z.B. des Vierfachen von Td, Pausen auftreten, die größer sind als Td, und daß ein derartiges Auftreten von Pausen als das Vorhandensein eines Nutzsignals ohne netzsynchrone Störungen (Störsignale) und das Ausbleiben eines derartiges Auftretens von Pausen als das Vorhandensein von Störungen interpretiert wird.

Ein Vorteil besteht darin, daß die Schaltungsanordnung weitgehend digital arbeiten kann, so daß sie in einem kleinen Gehäuse untergebracht werden kann, was eine Kostenreduzierung bedeutet und neue Anwendungsmöglichkeiten (z.B. in Videokameras) eröffnet. Demgegenüber benötigen bisherige Photomodule neben dem bereits erwähnten Kondensator als weiteres externes Bauelement noch einen Widerstand.

Weiter ist von Vorteil, daß der Stromverbrauch bei verbesserter Funktionalität deutlich verringert werden kann.

Weitere Vorteile der Erfindung bestehen darin, daß netzsynchrone Störsignale eindeutig von üblicherweise verwendeten Infrarot-Datenübertragungssignalen unterschieden werden können. Es wird somit eine hohe Übertragungssicherheit geschaffen, und eine Datenübertragung ist solange möglich, solange die Amplitude des Nutzsignals größer ist als die des Störsignals.

Durch die Erfindung ist es weiterhin möglich, bei Photomodulen und bei IR-Vorverstärkern mit weniger Typen auszukommen, was zu einer Kostenersparnis führt. Durch die digitale Realisierbarkeit kann die nötige Fläche für die Schaltungsanordnung (bei Ausführung als integrierte Schaltung die Chipfläche) verkleinert werden, was ebenfalls zu einer Kostenersparnis führt. Der Stromverbrauch kann verringert werden, wodurch insbesondere den Erfordernissen der Kunden entsprochen werden kann. Außerdem wird externer Schaltungsaufwand (ein Kondensator) vermieden, was der Kostenreduzierung und der kleinen Bauweise zugute kommt.

Die Erfindung ist anwendbar, wenn das Nutzsignal und das Störsignal gewisse Randbedingungen erfüllen. Dabei wird erfindungsgemäß die Unterscheidung zwischen einem Störsignal und einem (nicht notwendigerweise immer vorhandenen) Nutzsignal aufgrund des zeitlichen Auftretens der Signale vorgenommen. Netzsynchrone Störungen (durch Leuchtstofflampen, elektronisch getaktete Energiesparlampen usw.) treten periodisch auf. Die Wiederholdauer einer solchen Störung ist gleich der Netzperiode des verwendeten Wechselstromnetzes oder gleich der Hälfte der Netzperiode (in Deutschland ist die Wiederholdauer T = 20ms oder T = 10ms).

Die bei IR-Fernsteuerungen üblicherweise verwendeten Datenformate bestehen aus einem Block von Datenbits, gefolgt von einer Pause. Die zeitliche Länge des Blocks der Datenbits beträgt in der Regel 10 ms bis 50 ms. Die Pausendauer Tp beträgt normalerweise mehr als 30 ms.

Die Unterscheidung zwischen Störsignalen und Nutzsignalen basiert auf folgendem Unterscheidungskriterium:

Es wird eine Zeit Td definiert, die kürzer ist als die kürzesten Pausen, jedoch länger als die größte Periodendauer eines netzsynchronen Störers. Die kürzesten Pausen Tp sind in der Regel 30 ms lang. Die größte Periodendauer eines netzsynchronen Störers beträgt T = 20ms (entsprechend einer Netzfrequenz f = 50 Hz).

Wenn nun Td = 24 ms gewählt wird, sind beide genannten Bedingungen erfüllt. Nun werden die empfangenen Signale nach ihrem zeitlichen Verhalten hin untersucht. Es handelt sich um einen Störer, wenn in einem längeren Zeitabschnitt keine Pausen vorkommen, die größer sind als Td. Es handelt sich um ein Nutzsignal, wenn in einem längeren Zeitabschnitt Pausen vorkommen, die größer sind als Td. Diese Unterscheidung kann mit Hilfe einer Digitalschaltung getroffen werden.

Wenn darüber hinaus dafür gesorgt wird, daß die Amplitude der netzsynchronen Störungen an der Stelle, an der die genannte Unterscheidung vorgenommen wird, kleiner ist als die Amplitude der Nutzsignale, so läßt sich bei einer Ausführungsform der Erfindung durch die Anwendung unterschiedlich hoher Spannungsschwellen dafür sorgen, daß lediglich das Nutzsignal zur weiteren Auswertung weitergeleitet wird, und es läßt sich gemäß einer weiteren Ausführungsform der Erfindung eine Verstärkungsregelung anwenden, die dafür sorgt, daß das Störsignal bei eingeschwungenem Regelvorgang einen derartigen Pegel hat, daß das Nutzsignal vom Störsignal besonders leicht amplitudenmäßig getrennt und allein der Auswertung zugeführt werden kann.

Eine im Vergleich zum Nutzsignal kleinere Amplitude der Störsignale läßt sich möglicherweise durch Filterung und/oder dadurch erreichen, daß in besonders kritischen Fällen der IR-Signalempfänger möglicherweise vor Fremdlichtquellen etwas geschützt angeordnet wird, und daß der Benutzer, wie üblicherweise ohnehin vorgesehen, einen IR-Sender mit Richtwirkung verwendet und daher die IR-Signale möglichst zielgenau zum IR-Empfänger sendet, wobei selbstverständlich die Entfernung ein vorbestimmtes Maß nicht überschreiten darf.

Die Erfindung betrifft auch eine Vorrichtung zum Erkennen von netzsynchronen Störsignalen bei einer Datenübertragung, bei der zwischen Nutzsignalen Pausen auftreten, wobei die Zeitdauer der kürzesten Pause Tp sei und wobei die Netzfrequenz f ist. Zur Lösung der bereits genannten Aufgabe ist vorgesehen, daß Mittel zum Definieren einer Zeitspanne Td vorgesehen sind, die kürzer ist als die kürzesten Pausen Tp, aber länger als die größte Periodendauer 1/f oder 1/2f eines netzsynchronen Störers, daß Mittel vorgesehen sind, um zu prüfen, ob während eines Zeitraums T check > Td, vorzugsweise eines Mehrfachen, z.B. des Vierfachen von Td, Pausen auftreten, die größer sind als Td, und daß ein derartiges Auftreten von Pausen als das Vorhandensein eines Nutzsignals ohne netzsynchrone Störungen (Störsignale) und das Ausbleiben eines derartiges Auftretens von Pausen als das Vorhandensein von Störungen interpretiert wird.

Bei einer Ausführungsform der Erfindung ist vorgesehen, daß im Datenweg des Nutzsignals eine Amplitudenschwelle vorgesehen ist, die eine Auswertung des Nutzsignals nur zuläßt, wenn dessen Amplitude am Ausgang eines Bandpasses größer ist als diejenige des Störsignals. Das ermöglicht vorteilhaft eine Abtrennung von Störungen aus dem weg des Nutzsignals.

Bei einer Ausführungsform der Erfindung ist vorgesehen, daß im Auswerteweg der Störsignale eine Amplitudenschwelle vorgesehen ist, die kleiner ist als die im Datenweg des Nutzsignals vorgesehene genannte Ampltudenschwelle. Das ermöglicht es vorteilhaft, auch bei Vorhandensein von Störungen diese so auszuwerten, daß sie bei genügend kleiner Amplitude nicht als Störungen erkannt werden.

Bei einer Ausführungsform der Erfindung ist vorgesehen, daß in den Signalweg der Nutzsignale und Störsignale ein Verstärker mit regelbarer Verstärkung eingeschaltet ist, und daß seine Verstärkung so geregelt ist, daß im zeitlichen Mittel die Amplitude des Störsignals dem Schwellenwert der Amplitudenschwelle für die Störsignale gleich ist. Das ermöglicht es vorteilhaft, die Amplitude der Störungen so zu regeln, daß sie einen nahezu konstanten Wert hat, der tiefer liegt als die erstgenannte Amplitudenschwelle, wodurch Störungen vom weg des Nutzsignals noch besser ferngehalten werden können.

Bei einer Ausführungsform der Erfindung ist vorgesehen, daß die Regelung eine Einrichtung aufweist, die beim Nichterkennen von Störungen die Verstärkung des Verstärkers vergrößert, und beim Erkennen von Störungen verkleinert. Das ermöglicht vorteilhaft eine einfache und sichere Regelung.

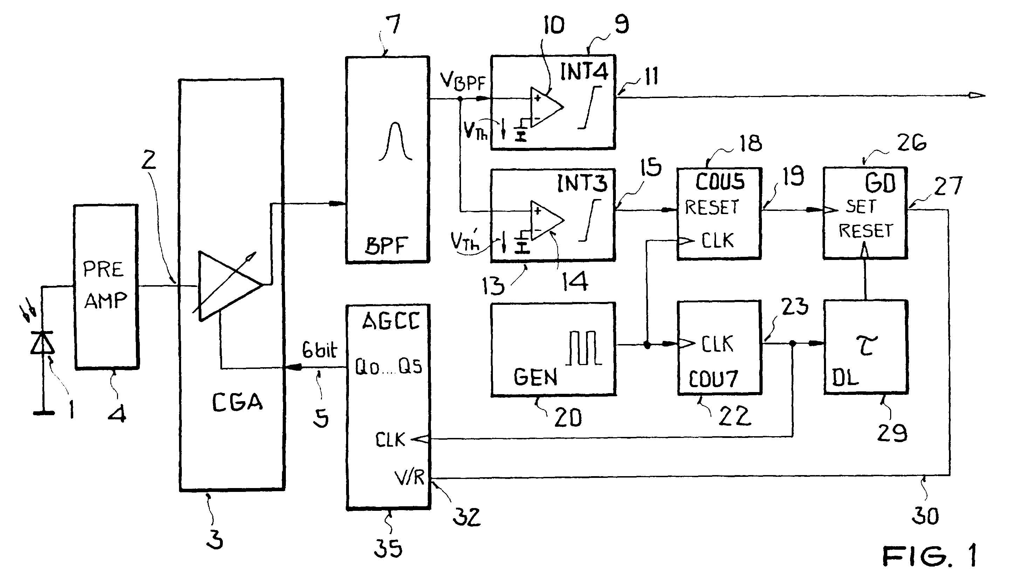

Weitere Merkmale und Vorteile der Erfindung ergeben sich aus der nachfolgenden Beschreibung von Ausführungsbeispielen der Erfindung anhand der Zeichnung, die erfindungswesentliche Einzelheiten zeigt, und aus den Ansprüchen. Die einzelnen Merkmale können je einzeln für sich oder zu mehreren in beliebiger Kombination bei einer Ausführungsform der Erfindung verwirklicht sein.

Die einzige Figur zeigt ein Blockschaltbild einer Vorverstärkerschaltung für digitale Signale, die von einem Lichtempfänger, insbesondere einem IR-Lichtempfänger stammen mögen, wobei die Vorverstärkerschaltung eine Einrichtung zum Erkennen von Störsignalen enthält, sowie eine Einrichtung, um eine automatische Verstärkungsregelung so zu beeinflussen, daß Nutzsignale getrennt von den Störsignalen einer weiteren Verarbeitung zuführbar sind.

Die Signale, die mittels des erfindungsgemäßen Verfahrens und der erfindungsgemäßen Vorrichtung verarbeitbar sind, können stark unterschiedlich sein. Bei IR-Fernsteuerungen wird im allgemeinen mit einer Trägerfrequenz im Bereich zwischen 30 kHz und 70 kHz gearbeitet. Für das folgende Beispiel soll angenommen werden, daß eine Trägerfrequenz von 30 kHz verwendet wird.

Als Beispiel soll weiterhin angenommen werden, daß ein vom Benutzer mit Hilfe seines Fernsteuer-Handgeräts erzeugtes IR-Signals sich folgenderweise zusammensetzt: Nach dem beliebig kurzen Drücken einer Taste, die beispielsweise einen anderen Kanal im Fernsehgerät einstellen soll, wird eine Folge von zehn sogenannten Bursts erzeugt. Jeder Burst setzt sich aus 15 Sinusschwingungen mit der Frequenz von 30 kHz, anschließend einer Pause entsprechend der Länge von 30 solchen Rechteckschwingungen, und schließlich wiederum 15 Rechteckschwingungen zusammen. Die Information, die übermittelt werden soll, wird durch den gegenseitigen Abstand des zweiten vom ersten Burst, des dritten vom zweiten Burst usw. bestimmt. Die zehn Bursts nehmen insgesamt einen Zeitraum von etwa 10 ms bis 50 ms in Anspruch.

In der Figur wird einem Pre-amplifier 4 das z. B. von einer IR-Photodiode 1 stammende Signal zugeführt. Die im Pre-amplifier 4 enthaltene Schaltung trennt niederfrequente Stromanteile der Photodiode 1 (0 bis ca. 20 kHz), wie sie z. B. durch Glühlampenlicht oder durch Sonnenlicht entstehen, vom Nutzsignal ab. Höherfrequente Stromanteile von der Photodiode 1 (größer als ca. 20 kHz) werden in eine äquivalente Spannung umgesetzt und einem Signaleingang 2 eines Verstärkers 3 (CGA) zugeführt. Anschließend gelangt das Signal zu einem Verstärker 3 (CGA), dessen Verstärkung über eine Leitung 5 einstellbar ist, und zwar wird die Verstärkung über ein sechs bit breites Datenwort eingestellt. Das verstärkte Ausgangssignal gelangt vom Verstärker 3 zu einem Bandpaß 7 (BPF), der ein bestimmtes definiertes Frequenzband (entsprechend der verwendeten Trägerfrequenz) ungehindert passieren läßt. Frequenzen außerhalb dieses Frequenzbandes werden gedämpft. Der Ausgang des Bandfilters 7 ist einerseits mit einem Eingang eines ersten Integrators 9 (INT 4) und andererseits mit einem Eingang eines zweiten Integrators 13 (INT 3) verbunden.

intern ist der erste Integrator 9 so gestaltet, daß das Eingangssignal für den ersten Integrator dem nicht-invertierenden Eingang eines Operationsverstärkers 10 zugeführt wird, dessen invertierender Eingang relativ zu Masse auf einer vorbestimmten Schwellenspannung VTh gehalten wird, wobei die Anordnung so getroffen ist, daß der Operationsverstärker 10 das Signal nur durchläßt, wenn das dem nicht-invertierenden Eingang zugeführte Signal positiv gegenüber Masse und größer ist als der Betrag der Schwellenspannung VTh. Im Bereich des Eingangs des ersten Integrators 9 wird somit eine Halbwellengleichrichtung ausgeführt und es werden nur Signale mit einer Mindestgröße VTh zu den weiteren Einrichtungen des ersten Integrators durchgelassen. Der erste Integrator 9 ist weiterhin so ausgebildet, daß er das am Ausgang des Operationsverstärkers 10 vorhandene Signal integriert, um Störungen durch Rauschspannungen möglichst klein zu halten, und daß er nur dann an einem Ausgang 11 des ersten Integrators 9 ein Signal mit dem Wert logisch 1 erzeugt, wenn vier unmittelbar aufeinanderfolgende Impulse der Trägerfrequenz von 30 kHz erkannt wurden.

Die Integration wird durch einen Vor-/Rückwärts-Zähler im ersten Integrator 9 bewirkt, der nur dann bis 4 hochzählt, wenn ihm 4 aufeinanderfolgende Impulse der Trägerfrequenz zugeführt werden. Unmittelbar aufeinanderfolgende Impulse haben einen Abstand von etwa 35 µs, und vom 1. bis zum 4. unmittelbar aufeinanderfolgenden Impuls der Trägerfrequenz vergehen somit etwa 100 µs. Wenn einmal der Ausgang 11 auf logisch 1 geschaltet worden ist, wird er erst dann dann wieder auf logisch 0 geschaltet, wenn zu drei, nicht zwingend aufeinanderfolgenden Zeitpunkten, zu denen Impulse vorhanden sein könnten (etwa alle 35 µs), kein Impuls detektiert werden kann. Dies wird ebenfalls durch den Vor-/Rückwärts-Zähler im ersten Integrator 9 festgestellt. Der Ausgang 11 bildet den Datenausgang, der in der Figur gezeigten Schaltung, und wie aus der späteren Beschreibung deutlich wird, besteht an diesem Datenausgang normalerweise das von Störimpulsen völlig befreite Nutzsignal zur Verfügung.

Das Nutzsignal am Ausgang 11 ist die Umhüllende des Trägerfrequenzsignals, und gegenüber diesem um 4 Impulse der Trägerfrequenz verzögert.

Es ist ein zweiter Integrator 13 (INT 3) vorgesehen, dessen Eingang ähnlich wie beim ersten Integrator 9 (INT 4) eine durch einen Operationsverstärker 14 gebildete Schwellenwertschaltung vorgeschaltete ist, deren Schwellenwert VTh' das 0,7fache des Schwellenwerts VTh des Operationsverstärkers 10 beträgt. Auch der zweite Integrator 13 führt die Integration mittels eines Zählers aus. Der zweite Integrator 13 liefert dann ein der Umhüllenden der ihm zugeführten trägerfrequenten Information entsprechendes Ausgangssignal, wenn die Komperatorschwelle VTh' drei Mal in Serie überschritten wird. Wird der Schwellenwert VTh' einmal nicht erreicht, so wird der zweite Integrator 13 zurückgesetzt, d.h. sein Ausgang wird wieder auf logisch Null gesetzt.

Das Ausgangssignal des zweiten Komparators 13 steht an einem Ausgang 15 zur Verfügung und wird einem 5-Bit-Zähler 18 (COU5) zugeführt, und zwar dessen Rücksetzeingang (RESET). Mit einem Takteingang (CLK) des Zählers 18 ist der Ausgang eine Taktgenerators 20 (GEN) verbunden, der einen Takt von 1,33 kHz bereitstellt. Der Ausgang des Taktgenerators 20 ist auch mit dem Takteingang (CLK) eines 7-Bit-Zählers 22 (COU7) verbunden. Der 5-Bit-Zähler 18 ist ein Vorwärtszähler und zählt bei jeder positiven Flanke am Eingang CLK um einen Zählerstand weiter. Der Zähler 18 wird durch ein Signal am RESET-Eingang asynchron zurückgesetzt. Der Zähler 18 liefert bei Erreichen eines Zählerstands 32 ein kurzes Triggersignal an seinem Ausgang 19. Wenn der Zählerstand 32 erreicht ist, führt der nächste dem Eingang CLK zugeführte Taktimpuls zum Zählerstand 0.

Der 7-Bit-Zähler 22 ist ein Vorwärtszähler und zählt bei jeder positiven Flanke an seinem Eingang CLK um einen Zählerstand weiter. Der Zähler liefert bei Erreichen des Zählerstands 128 ein kurzes Triggersignal an seinem Ausgang 23. Wenn der Zählerstand 128 erreicht ist, so führt der nächste dem Eingang CLK zugeführte Taktimpuls zum Zählerstand 0.

Das Ausgangssignal des Zählers 18 wird einem Setzeingang (SET) eines Lückenerkennungsspeichers 26 (GD) zugeführt. Dieser Speicher arbeitet wie ein RS-Flipflop. Durch ein Signal am setzeingang wird der Ausgang 27 auf den Wert logisch 1 gesetzt, durch ein Signal am Rücksetzeingang (RESET) wird der Ausgang 27 zurückgesetzt. Dieses Zurücksetzen erfolgt über den vom Ausgang des Zählers 22 gelieferten Impuls, der dem Rücksetzeingang des Speichers 26, durch eine Verzögerungseinrichtung 29 (DL) etwas verzögert, zugeführt wird.

Das Ausgangssignal des Speichers 26 wird über eine Leitung 30 einem Vorwärts-/Rückwärts-Steuereingang 32 (V/R) eines Zählers 35 für die Regelung der Verstärkung des Verstärkers 3 zugeführt. Der Zähler 35 (AGCC) ist ein 6-Bit-Vorwärts-/Rückwärtszähler, der die Verstärkung des Verstärkers 3 (CGA) einstellt. Eine positive Flanke am Takteingang (CLK) des Zählers 35, die an diesen Takteingang vom Ausgang des 7-BitZählers 22 geliefert wird, bewirkt eine Zählerstandsveränderung um einen Zählschritt. Der logische Zustand am Eingang V/R bestimmt die Zählrichtung.

Die Taktfrequenz von 1,33 kHz des Generators 20 entspricht einem Impulsabstand von etwa 0,75 ms. Die Schaltungsanordnung arbeitet, wie oben bereits erwähnt, mit einer Zeitspanne Td = 24 ms. Es wird angenommen, daß es sich um eine Störung handelt, wenn in einem längeren Zeitabschnitt (T check = 96 ms) keine Pausen vorkommen, die größer sind als Td. Es wird ein Nutzsignal angenommen, wenn in einem längeren Zeitabschnitt (T check) Pausen vorkommen, die größer sind als Td. Die Zeit T check = 96 ms wird durch den 7-Bit-Zähler 22 erzeugt. Wenn vom zweiten Integrator 13 (INT 3) für eine Zeitspanne von T = 24 ms kein Signal geliefert wird, so entsteht am Ausgang des 5-Bit-Zählers 18 ein Triggersignal. Dieses Triggersignal setzt nun den Speicher 26. Dessen Ausgang zeigt nun an, daß eine Pause T > 24 ms aufgetreten ist. Dieses Ausgangssignal dient als Zählrichtungseingangssignal für den Zähler 35 (AGCC). Ist der Ausgang des Speichers 26 gesetzt, so zählt der Zähler 35 beim Eintreffen eines Taktes an seinem Eingang CLK um einen Zählerstand zurück. Dadurch steigt die Verstärkung des Verstärkers 3 um 1 dB an. Ist der Ausgang des Speichers 26 beim Eintreffen eines Taktes am Takteingang CLK des Zählers 35 nicht gesetzt, so zählt der Zähler 35 um einen Zählerstand hoch. Dadurch sinkt die Verstärkung des Verstärkers 3 um 1 dB.

Die Verzögerungsleitung 29 sorgt dafür, daß der Speicher 26 erst zurückgesetzt wird, nachdem der Zähler 35 gezählt hat.

Somit ergibt sich für den Ausgang des zweiten Integrators 13 (INT 3) folgende Funktion:

In einem festen Zeitraster von T check = 96 ms wird die vergangene Zeitspanne von T check = 96 ms untersucht. Trat am Ausgang des zweiten Integrators 13 während dieser Zeitspanne eine Signallücke von T > Td auf (und damit eine Pause von T > Td), so wird die Verstärkung des Verstärkers 3 und somit der Verstärkung der ganzen Anordnung um 1 dB erhöht. Trat während dieser genannten Zeitspanne keine solche Lücke auf, so wird die Verstärkung des Verstärkers 3 um 1 dB verringert.

Die zu bewertenden Signale durchlaufen den Verstärker 3 und den Bandpaß 7. Danach durchlaufen die Signale sowohl den ersten Integrator 9 (bei ausreichender Amplitude) als auch parallel zu diesem den zweiten Integrator 13. Der Verstärker 3 besitzt entsprechend den möglichen Zählerständen des Zählers 35 (AGCC) eine Regeldynamik von dV = 63 dB. Die folgenden Merkmale sind besonders wichtig:

Die Verstärkung des Bandpasses 7 ist konstant (bei Verwendung passiver Bauelemente ist die Verstärkung etwa 1). Der erste Integrator 9 läßt Signale passieren, die größer sind als VTh. Der zweite Integrator 13 läßt an seinem Eingang Signale passieren, die größer sind als VTh'.

Der Ausgang des ersten Integrators 9 ist der Datenausgang. Dieser Ausgang stellt das digitale Datenwort entsprechend den ankommenden Fernbediensignalen seriell zur Verfügung. Netzsynchrone Störsignale führen bei eingeschwungener Regelung nicht zum Schalten dieses Ausgangs, d.h. dieser Ausgang ist bei eingeschwungener Regelung im wesentlichen frei von Störungen.

Die oben beschriebenen Funktionsmerkmale der Regelung führen zu folgendem Regelverhalten:

Beim Eintreffen von netzsynchronen Signalen mit T < 24 ms kommen diese zunächst am Datenausgang des ersten Integrators 9 durch.

Nun wird die Verstärkung des Verstärkers 3 in einem Intervall von T check = 96 ms so lange um Schritte von jeweils 1 dB verringert, bis die Signalamplitude am Ausgang des Bandpasses 7 kleiner wird als VTh'. Jetzt erscheint am Ausgang 15 des zweiten Integrators 13 kein Signal mehr. Anschließend pendelt die Signalamplitude VBPF des den Bandpaß 7 verlassenden Signals um diesen Wert, da der Zähler 35 für die automatische Verstärkungsregelung ständig seine Zählrichtung ändert. Wenn die Signalamplitude kleiner ist als VTh', werden die oben beschriebenen Pausen erkannt, was eine Verstärkungserhöhung bewirkt. Dadurch wird die Schwelle des Operationsverstärkers 14 des zweiten Integrators 13 wieder überschritten, und der Vorgang wiederholt sich. Die Verstärkung ist nun eingeregelt. Die Signalamplitude VBPF entspricht der Spannung VTh'. Weil der erste Integrator 9 nur Signale passieren läßt, die größer sind als VTh (entsprechend dem größeren Schwellenwert), kommen diese Störsignale nicht mehr zum Ausgang des ersten Integrators 9 durch.

Beim Eintreffen von Fernbediensignalen treten innerhalb von T check = 96 ms immer Signalpausen auf, die größer sind als Td = 24 ms. Daher wird die Verstärkung des Verstärkers 3 so lange erhöht, bis die maximale Verstärkung erreicht ist, oder bis Störsignale bzw. Rauschen so oft den Schwellenwert VTh' überschreiten, daß im statistischen Mittel nur noch eine Pause mit T > Td während eines Zeitintervalls von T = 2 x T check auftritt. In diesem Falle ist der Verstärker 3 wieder eingeregelt, da die Zählrichtung des Zählers 35 im statistischen Mittel ausgeglichen ist. In diesem Zustand ist die Signalspannung VBPF so groß, daß sowohl die Schwelle VTh' als auch die Schwelle VTh überschritten wird. Daher kommen die Signale über den ersten Integrator 9 zu dem Datenausgang 11 durch.

Das Ausgangssignal des Bandfilters 7 weist keinen Gleichspannungsanteil auf. Es pendelt somit um einen Nullpegel. Die maximale Regelzeit, um den Verstärker 3 von seiner minimalen Verstärkung auf die maximale Verstärkung zu regeln oder umgekehrt, beträgt 63 x 96 ms ≈ 6 s. Die automatisch geregelte Verstärkung des Verstärkers 3 wird alle 96 ms neu eingestellt. Die Änderung beträgt immer eine Zählerstellung des Zählers 35, und somit im Beispiel immer 1 dB. Bei minimaler Verstärkung des Verstärkers 3 sollte die Reichweite des IR-Senders noch größer als 1 Meter sein, damit sehr lange Impulsfolgen, wie sie beim Programmieren des Gerätes auftreten können, verarbeitet werden können.

Der Unterschied der Schwellenspannungen der beiden Integratoren 9 und 13 von dem Beispiel 30% ist so gewählt, daß etwaige am Datenausgang 11 auftretende Störimpulse nur so selten vorkommen, daß dies nicht zu einer Beeinträchtigung der Gebrauchsfähigkeit der Fernsteuerung führt.

Die beiden relevanten Schwellenwerte der Integratoren liegen nahe beieinander. Daher können sich Offsetfehler nicht so leicht bemerkbar machen.

Die Anordnung kann als integrierte Schaltung ausgeführt werden, wobei die Photodiode zweckmäßig ein separates Bauelement ist.

## Patentansprüche

1. Verfahren zum Erkennen von netzsynchronen Störsignalen bei einer Datenübertragung, bei der zwischen Nutzsignalen Pausen auftreten, wobei die Zeitdauer der kürzesten Pause Tp sei und wobei die Netzfrequenz f ist, dadurch gekennzeichnet, daß eine Zeitspanne Td definiert wird, die kürzer ist als die kürzesten Pausen Tp, aber länger als die größte Periodendauer 1/f oder 1/2f eines netzsynchronen Störers, daß geprüft wird, ob während eines Zeitraums T check > Td, vorzugsweise eines Mehrfachen, z.B. des Vierfachen von Td, Pausen auftreten, die größer sind als Td, und daß ein derartiges Auftreten von Pausen als das Vorhandensein eines Nutzsignals ohne netzsynchrone Störsignale und das Ausbleiben eines derartiges Auftretens von Pausen als das Vorhandensein von Störsignalen interpretiert wird.

2. Verfahren nach Anspruch 1, dadurch gekennzeichnet, daß die Weiterleitung des Nutzsignals von der Feststellung der genannten Pausen dadurch entkoppelt ist, daß das Nutzsignal nur bei überschreiten einer vorbestimmten Amplitude weitergeleitet wird.

3. Verfahren nach Anspruch 2, dadurch gekennzeichnet, daß das Störsignal nur bei Überschreiten einer weiteren vorbestimmten Amplitude, die kleiner ist als die erstgenannte Amplitude des Nutzsignals, zur Feststellung des Nicht-Vorhandenseins von Pausen ausgewertet wird.

4. Verfahren nach Anspruch 3, dadurch gekennzeichnet, daß das Nutzsignal und die Störsignale gemeinsam einer Verstärkungsregelung unterzogen werden, durch die die Störsignale bei eingeschwungener Regelung auf eine solche Amplitude geregelt werden, daß im zeitlichen Mittel etwa gleich häufig ein Vorhandensein und ein Nicht-Vorhandensein von Pausen > Td festgestellt wird.

5. Vorrichtung zum Erkennen von netzsynchronen Störsignalen bei einer Datenübertragung, bei der zwischen Nutzsignalen Pausen auftreten, wobei die Zeitdauer der kürzesten Pause Tp sei und wobei die Netzfrequenz f ist, dadurch gekennzeichnet, daß Mittel (18) zum Definieren einer Zeitspanne Td vorgesehen sind, die kürzer ist als die kürzesten Pausen Tp, aber länger als die größte Periodendauer 1/f oder 1/2f eines netzsynchronen Störers, daß Mittel (18, 22, 26) vorgesehen sind, um zu prüfen, ob während eines Zeitraums T check > Td, vorzugsweise eines Mehrfachen, z.B. des Vierfachen von Td, Pausen auftreten, die größer sind als Td, und daß ein derartiges Auftreten von Pausen als das Vorhandensein eines Nutzsignals ohne netzsynchrone Störsignale und das Ausbleiben eines derartiges Auftretens von Pausen als das Vorhandensein von Störsignalen interpretiert wird.

6. Vorrichtung nach Anspruch 5, dadurch gekennzeichnet, daß im Datenweg des Nutzsignals eine Amplitudenschwelle (10) vorgesehen ist, die eine Auswertung des Nutzsignals nur zuläßt, wenn dessen Amplitude am Ausgang eines Bandpasses (7) größer ist als diejenige des Störsignals.

7. Vorrichtung nach Anspruch 6, dadurch gekennzeichnet, daß im Auswerteweg der Störsignale eine Amplitudenschwelle (14) vorgesehen ist, die kleiner ist als die im Datenweg des Nutzsignals vorgesehene genannte Amplitudenschwelle (10).

8. Vorrichtung nach Anspruch 7, dadurch gekennzeichnet, daß in den Signalweg der Nutzsignale und Störsignale ein Verstärker (3) mit regelbarer Verstärkung eingeschaltet ist, und daß seine Verstärkung so geregelt ist, daß im zeitlichen Mittel die Amplitude des Störsignals dem Schwellenwert der Amplitudenschwelle (14) für die Störsignale gleich ist.

9. Vorrichtung nach Anspruch 8, dadurch gekennzeichnet, daß die Regelung eine Einrichtung (18, 22, 26, 35) aufweist, die beim Nichterkennen von Störungen die Verstärkung des Verstärkers (3) vergrößert, und beim Erkennen von Störungen verkleinert.

10. Vorrichtung nach einem der Ansprüche 5 bis 9, dadurch gekennzeichnet, daß die Vorrichtung digital arbeitet.

## Claims

1. A process for detecting mains-synchronous interference signals in a data transmission in which pauses occur between useful signals, wherein the duration of the shortest pause is to be Tp and wherein the mains frequency is f,
characterised in that a time interval Td is defined which is shorter than the shortest pauses Tp but longer than the maximum period duration 1/f or 1/2f of a mains-synchronous interference source, that it is checked whether, during a time interval, T check > Td, preferably a multiple of Td, for example the quadruple of Td, pauses occur which are greater than Td, and that such an occurrence of pauses is interpreted as the presence of a useful signal with no mains-synchronous interference signals and the absence of such an occurrence of pauses is interpreted as the presence of interference signals.

2. A process according to Claim 1, characterised in that the forwarding of the useful signal is decoupled from the determination of the foresaid pauses in that the useful signal is forwarded only upon the overshooting of a predetermined amplitude.

3. A process according to Claim 2, characterised in that the interference signal is evaluated only upon the overshooting of a further predetermined amplitude, which is smaller than the first-mentioned amplitude of the useful signal, for determining the absence of pauses.

4. A process according to Claim 3, characterised in that the useful signal and the interference signals are commonly subjected to a gain control by which, with steady-state control, the interference signals are controlled to an amplitude such that on a time average the presence and absence of pauses > Td are determined approximately equally often.

5. A device for detecting mains-synchronous interference signals in a data transmission in which pauses occur between useful signals, wherein the duration of the shortest pause is to be Tp and wherein the mains frequency is f,
characterised in that means (18) are provided for defining a time interval Td which is shorter than the shortest pauses Tp but longer than the maximum period duration 1/f or 1/2f of a mains-synchronous interference source, that means (18, 22, 26) are provided for checking whether during a time interval, T check > Td, preferably a multiple of Td, for example the quadruple of Td, pauses occur which are greater than Td, and that such an occurrence of pauses is interpreted as the presence of a useful signal with no mains-synchronous interference signals and the absence of such an occurrence of pauses is interpreted as the presence of interference signals.

6. A device according to Claim 5, characterised in that in the data path of the useful signal an amplitude threshold (10) is provided which permits an evaluation of the useful signal only if its amplitude at the output of a band-pass filter (8) is greater than that of the interference signal.

7. A device according to Claim 6, characterised in that in the evaluation path of the interference signals an amplitude threshold (14) is provided which is smaller than the foresaid amplitude threshold (10) provided in the data path of the useful signal.

8. A device according to Claim 7, charactiersed in that an amplifier (3) with controllable gain is connected into the signal path of the useful signals and interference signals, and that its gain is controlled such that on a time average the amplitude of the interference signal is equal to the threshold value of the amplitude threshold (14) for the interference signals.

9. A device according to Claim 8, characterised in that the control comprises a device (18, 22, 26, 35) by which the gain of the amplifier (3) is increased in the event of the non-detection of interferences and is reduced in the event of the detection of interferences.

10. A device according to one of Claims 5 to 9, characterised in that the device operates digitally.

## Revendications

1. Procédé pour identifier des signaux parasites synchrones avec le réseau, lors d'une transmission de données, lors de laquelle des pauses apparaissent entre des signaux utiles, la durée de la pause la plus courte étant Tp et la fréquence du réseau étant f, caractérisé en ce qu'on définit un intervalle de temps Td qui est inférieur à aux pauses les plus courtes Tp, mais supérieur à la durée maximale de période 1/f ou 1/2f d'un dispositif produisant un parasitage synchrone avec le réseau, qu'on vérifie si pendant un intervalle de temps T check > Td, de préférence un multiple, par exemple le quadruple de Td, il apparaît des pauses qui sont supérieures à Td et qu'une telle apparition de pauses est interprétée en tant que présence d'un signal utile sans signaux parasites synchrones avec le réseau et que l'absence d'une telle apparition de pauses est interprétée en tant que présence de signaux parasites.

2. Procédé selon la revendication 1, caractérisé en ce que la transmission du signal utile est découplée de la détermination des pauses indiquées par le fait que le signal utile est transmis uniquement lors du dépassement d'une amplitude prédéterminée.

3. Procédé selon la revendication 2, caractérisé en ce que c'est seulement lors du dépassement d'une autre amplitude prédéterminée, qui est inférieure à l'amplitude indiquée en premier lieu du signal utile, que le signal parasite est exploité pour la détermination de l'absence de pauses.

4. Procédé selon la revendication 3, caractérisé en ce que le signal utile et des signaux parasites sont soumis en commun à une régulation d'amplification, au moyen de laquelle les signaux parasites sont réglés, lors d'une régulation permanente, sur une amplitude telle qu'une présence et une absence de pauses > Td sont déterminées comme apparaissant approximativement aussi fréquemment l'une que l'autre en moyenne dans le temps.

5. Dispositif pour identifier des signaux parasites synchrones avec le réseau, lors d'une transmission de données, lors de laquelle des pauses apparaissent entre des signaux utiles, la durée de la pause la plus courte étant Tp et la fréquence du réseau étant f, caractérisé en ce que des moyens (18) sont prévus pour définir un intervalle de temps Td qui est inférieur aux pauses les plus courtes Tp, mais est supérieur à la durée maximale de période 1/f ou 1/2f d'un dispositif produisant un parasitage synchrone avec le réseau, que des moyens (18,22,26) sont prévus pour vérifier si pendant un intervalle de temps T check > Td, de préférence un multiple, par exemple le quadruple de Td, il apparaît des pauses qui sont supérieures à Td et qu'une telle apparition de pauses est interprétée en tant que présence d'un signal utile sans signaux parasites synchrones avec le réseau et que l'absence d'une telle apparition de pauses est interprétée en tant que présence de signaux parasites.

6. Dispositif selon la revendication 5, caractérisé en ce que dans le trajet des données du signal utile est prévu un circuit à seuil d'amplitude (10), qui autorise une exploitation du signal utile uniquement lorsque son amplitude à la sortie d'un filtre passe-bande (7) est supérieure à celle du signal parasite.

7. Dispositif selon la revendication 6, caractérisé en ce que dans le trajet d'exploitation des signaux parasites est prévu un circuit à seuil d'amplitude (14), dont le seuil est inférieur à celui du circuit à seuil d'amplitude indiqué (10), prévu dans le trajet de transmission des données du signal utile.

8. Dispositif selon la revendication 7, caractérisé en ce que dans le trajet de transmission des signaux utiles et des signaux parasites est inséré un amplificateur (3) possédant une amplification réglable, et que son amplification est réglée de telle sorte que l'amplitude du signal parasite est égale à la valeur de seuil du circuit à seuil d'amplitude (14) pour les signaux parasites en moyenne dans le temps.

9. Dispositif selon la revendication 8, caractérisé en ce que le système de régulation comporte un dispositif (18,22,26,35) qui, lorsqu'aucun parasitage n'est identifié, augmente l'amplification de l'amplificateur (3) et, dans le cas de l'identification de parasitages, réduit cette amplification.

10. Dispositif selon l'une des revendications 5 à 9, caractérisé en ce que le dispositif travaille de façon numérique.
